# EUROPEAN PATENT APPLICATION

(11) **EP 2 806 470 A1**
(43) Date of publication of application: **26.11.2014**
(21) Application number: 14169226.9
(22) Date of filing: 21.05.2014
(51) Int. Cl.: H01L 33/20, H01L 33/00, H01S 5/02

(54) **Semiconductor optical emitting device with lens structure formed in a cavity of a substrate of the device**

(30) Priority: 21.05.2013 US 201313898964
(71) Applicant: LSI Corporation, San Jose, CA 95131 (US)
(72) Inventor: Freund, Joseph M., Fogelsville, PA 18051 (US)
(74) Representative: Dilg, Haeusler, Schindelmann Patentanwaltsgesellschaft mbH

(57) **Abstract**

A semiconductor optical emitting device comprises an at least partially transparent substrate, an active semiconductor structure arranged on a first side of the substrate, and a lens structure formed at least partially within a cavity on a second side of the substrate. Light generated by the active semiconductor structure is emitted through the substrate and the lens structure. The cavity may comprise a bottom surface and a plurality of sidewalls, with the plurality of sidewalls extending upward from the bottom surface to an upper surface of the second side of the substrate, although numerous other cavity shapes are possible. The bottom surface may be convex or concave. The bottom surface and the plurality of sidewalls may form a portion of a sphere with a plane parallel to the upper surface of the second side of the substrate.

## Description

### Field

Thefield relates generally to semiconductor devices, and more particularly to semiconductor optical emitting devices.

### Background

Many different types of semiconductor optical emitting devices are known in the art, including surface emitting lasers and light emitting diodes.Some of these devices utilize gallium nitride (GaN) to form an active semiconductor structure for light generation. Surface emitting lasers and laser diodes based on GaN have come into widespread use in numerous applications, including traffic lights and other types of solid-state lighting, indoor and outdoor electronic displays, backlighting for liquid crystal displays, and many others. These GaN-based devices have a number of significant advantages, such as good optical beam characteristics and ease of batch fabrication and packaging.Other types of semiconductor optical emitting devices provide similar advantages using other semiconductor materials.

### Summary

Inone embodiment, a semiconductor optical emitting device comprises an at least partially transparent substrate, an active semiconductor structure arranged on a first side of the substrate, and a lens structure formed at least partially within a cavity on a second side of the substrate. Light generated by the active semiconductor structure is emitted through the substrate and the lens structure.

By way of example only, the cavity may comprise a bottom surface and a plurality of sidewalls, with the plurality of sidewalls extending upward from the bottom surface to an upper surface of the second side of the substrate, although numerous other cavity shapes are possible. The bottom surface may be convex or concave. The bottom surface and the plurality of sidewalls may form a portion of a sphere with a plane parallel to the upper surface of the second side of the substrate.

The semiconductor optical emitting device may be implemented in the form of a surface emitting laser or a light emitting diode, or in other forms.

One or more surface emitting lasers, light emitting diodes or other semiconductor optical emitting devices may be implemented with associated control circuitry in a lighting system, an electronic display or another type of system or device. As a more particular example, multiple semiconductor optical emitting devices may be combined in the form of an array having associated control circuitry and implemented in a lighting system, an electronic display or another type of system or device.

Other embodiments of the invention include but are not limited to methods, apparatus, integrated circuits and processing devices.

### Brief Description of the Drawings

FIG. 1 is a cross-sectional view of an exemplary semiconductor optical emitting device comprising a surface emitting laser having a lens structure formed in a cavity of a substrate in an illustrative embodiment.
FIGS. 2 through 11 illustrate respective steps in a process of forming the cavity in the substrate of the surface emitting laser of FIG. 1.
FIGS. 12 through 21 show cross-sectional views of different possible configurations for a lens structure and a cavity in a substrate of a surface emitting laser in illustrative embodiments.
FIG. 22 shows a top-down view of a wafer with a plurality of cavities and lens structures formed therein in an illustrative embodiment.
FIGS. 23 through 26 show top-down views of different possible configurations for a lens structure and a cavity in a substrate of a surface emitting laser in illustrate embodiments.
FIG. 27shows an integrated circuit comprising an array of surface emitting lasers and associated control circuitry.
FIG. 28shows a processing device that incorporates the integrated circuit of FIG. 27.

### Detailed Description

Embodimentsof the invention will be illustrated herein in conjunction with exemplary surface emitting lasers (SELs)each of which includes at least one lens structure formed in a cavity of a substrate. It should be understood, however, that embodiments of the invention can be implemented using a wide variety of alternative types and configurations of semiconductor optical emitting devices, including, for example, light emitting diodes (LEDs).

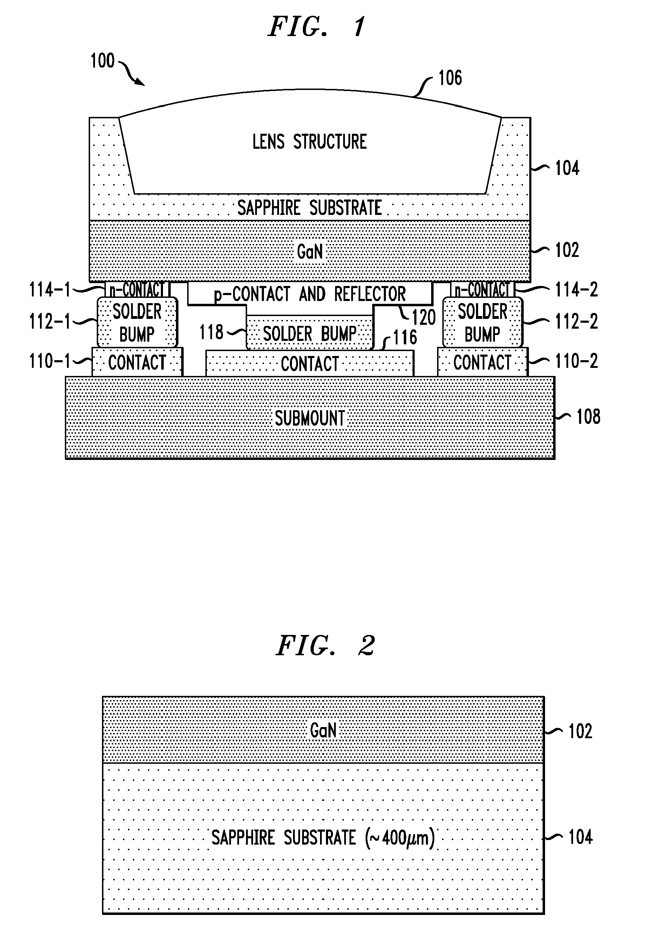

FIG. 1 shows an exemplary semiconductor optical emitting device in the form of an SEL 100. The SEL 100 comprises an active semiconductor structure 102 arranged on a first side of a sapphire substrate 104.

The active semiconductor structure 102 in this embodiment illustratively comprises a GaN SEL structure, but numerous other semiconductor materials and configurations can be used in otherembodiments. The GaN SEL structure may be epitaxially grown or otherwise formed on the sapphire substrate using well-known techniques.

The sapphire substrate 104 is substantially transparent at one or more wavelengths of the light generated by the active semiconductor structure 102, and is an example of what is more generally referred to herein as an "at least partially transparent substrate." Such a substrate may be substantially transparent for a particular range of wavelengths that encompass typical wavelengths of light generated by the active semiconductor structure 102. A wide variety of different types of substrates suitable for having cavities formed therein using etching or other processing operations may be used in other embodiments. Accordingly, use of a sapphire substrate is not required.

A second side of the sapphire substrate 104 in this embodiment has a cavity formed therein. A lens structure 106 is formed in the cavity in FIG. 1. The first and second sides of the sapphire substrate 104 as illustrated in the figure correspond to respective lower and upper primary surfaces of the substrate, and may also be referred to as respective front and back sides of the substrate, although the term "side" as used in this context is intended to be broadly construed so as to encompass other substrate arrangements relative to the active semiconductor structure 102 and lens structure 106.

As will be discussed in further detail below, the cavity may be a variety of different shapes and configurations, and the lens structure 106 may be one of or a combination of a variety of lens types. The lens structure may be a microlens with a diameter less than one millimeter and as small as a few µm. The size of the lens structure used in a particular embodiment may be selected based in part on a size of the sapphire substrate 104 and/or the active semiconductor structure 102.

The SEL 100 further comprises a submount 108 configured to support the active semiconductor structure 102 and its associated substrate 104.Part of an upper surface of the submount 108 underlies an active region stripe of the active semiconductor structure 102. This arrangement of active semiconductor structure 102, substrate 104 and submount 108 is an example of a flip-chip configuration of an SEL. Although such flip-chip configurations can provide enhanced thermal management and optical coupling of light emission, other types and arrangements of semiconductor optical emitting device packaging can be used.

Light is generated in the SEL 100 via the active region stripe of the active semiconductor structure 102, although numerous other light generation arrangements may be used in other embodiments. At least a portion of the light generated by the active semiconductor structure 102 is emitted through the substrate 104 from the first side of the substrate to the second side of the substrate through the lens structure 106. The lens structure 106 in FIG. 1 comprises a plano-convex cylindrical lens. However, as will be detailed below, a number of other lens types may be used.

As indicated above, the submount 108 supports the active semiconductor structure 102 and the substrate 104. Multiple contacts 110 and 116are formed on an upper surface of the submount 108 for coupling via solder bumps 112 and 118 to corresponding contacts 114 and 120on a lower surface of the active semiconductor structure 102.

More particularly, in this embodiment, the contacts formed on the upper surface of the submount 108 include first and second submount contacts 110-1 and 110-2 coupled via respective solder bumps 112-1 and 112-2 to respective n-contacts 114-1 and 114-2 of the active semiconductor structure 102, and a third contact 116coupled via solder bump 118 to a p-contact 120 of the active semiconductor structure 102. The p-contact 120 is formed integrally with or otherwise associated with a reflector of the active semiconductor structure.

The above-noted reflector is generally arranged to reflect light generated in the active region stripe away from the lower surface of the active semiconductor structure 102 and back toward the substrate 104.

Again, the SEL 100 is exemplary only, and other types of SEL structures or more generally semiconductor optical emitting devices may be used. For example, as indicated previously, the SEL structure used as an active semiconductor structure in FIG. 1 could be replaced in other embodiments with other types of semiconductor laser structures as well as LED structures.

The lens structure 106 may be formed in a cavity formed by etching through a patterned opening in a passivation layer formed on the second side of the substrate 104, as will now be described with reference to FIGS. 2 through 11.

FIG. 2 shows the active semiconductor structure 102 attached to the first side of the sapphire substrate 104 with the sapphire substrate being of a particular initial thickness, in this example approximately 400 micrometers (µm). It is assumed that the GaN SEL structure is formed by growing multiple GaN layers epitaxially on the sapphire substrate using metal organic vapor deposition (MOCVD). Similar techniques may be used to form other types of active semiconductor structures, such as LED structures.

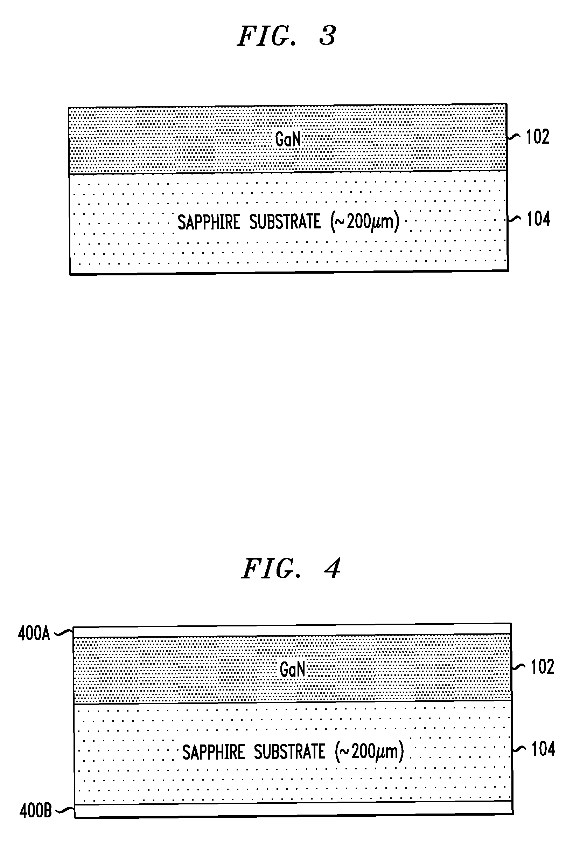

The second side of the sapphire substrate 104 is then ground down to a desired thickness, in thisexample approximately 200 µm, resulting in the structure shown in FIG. 3.As noted above, the first and second sides of the substrate 104 are also referred to herein as front and back sides, respectively.Accordingly, in the present embodiment a back side grinding process is assumed to be applied in order to reduce the thickness of the substrate in the manner shown in FIG. 3.

Although the desired thickness in this example is approximately 200 µm, numerous other thicknesses may be used. It should therefore be appreciated that thicknesses and other dimensions referred to herein are exemplary only.The desired thickness of the substrate 104 as illustrated in FIG. 3 may be selected based on a particular type of lens structure which will be formed within a cavity in the substrate. For example, the desired thickness may be selected such that a designated minimum amount of substrate material remains after formation of one or more cavities in the substrate in order to reduce the mean free path and improve light extraction. Also, a GaN buffer layer of the active semiconductor structure 102 may be used as an etch stop to provide additional reduction in the mean free path.

Passivation layers 400A and 400B are then formed on the upper and lowersurfaces of the FIG. 3 structure, as illustrated in FIG. 4.Such layers may be deposited, for example, using plasma-enhanced chemical vapor deposition (PECVD).The passivation layers may be approximately 1.0 to 2.0µm thick and formed from silicon dioxide (SiO₂), although other thicknesses and materials could be used.

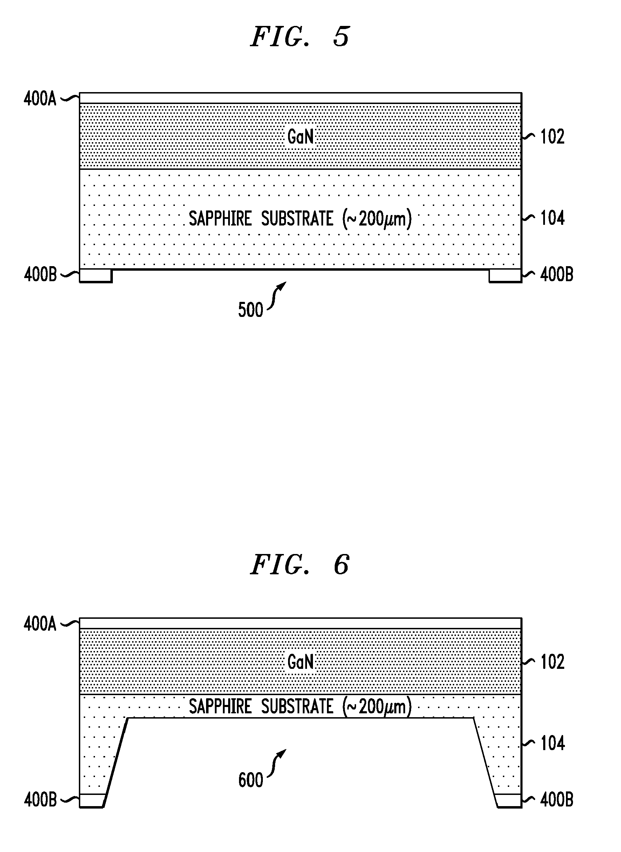

A patterned opening 500 is formed in the passivation layer 400B that overlies the second side of the substrate 104, as shown in FIG. 5. This may involve, for example, etching the passivation layer 400B into stripe masks using conventional wet etching techniques, such as a buffer-oxide-etch (BOE) process. The shape of the opening 500 may vary depending on the cavity to be formed in the substrate 104. The opening may be a rectangular pattern, a circular pattern, or various other patterns. In FIG. 5, the opening 500 is a square pattern with a size of 500 µm x 500 µm for formation of a cylindrical type lens 106 as shown in FIG. 1. It is important to note, however, that various other sizes and geometries may be used in other embodiments. For example, in some embodiments a circular opening in the passivation layer 400B may be formed.

A cavity 600 is then etched into the second side of the substrate 104 through the patterned opening in the passivation layer 400B, as illustrated in FIG. 6. As in the FIG. 1 embodiment, the cavity 600 is illustrated as an inverted mesa. As will be detailed below, various other cavity shapes and geometries may be utilized. In some embodiments, the etch profile may be aligned along the <1-100> sapphire orientation for a symmetrical mesa cavity. Other orientations, however, may be used in other embodiments. For a <11-20> sapphire orientation, an asymmetrical cavity geometry may be etched.

The cavity 600 may be formed by wet etching with a mixed solution of H₂SO₄:H₃PO₄ in a ratio of 3:1.A suitable etch temperature is approximately 270 to 300 °C.Wet etching of this type at 300 °C for 12 hoursresults in a cavity depth of approximately 160 to 170 µm. Process parameters such as etch time and temperature, solutions, passivation layer thickness and patterned opening size can be varied to alter the depth, width and shape of the cavity 600.

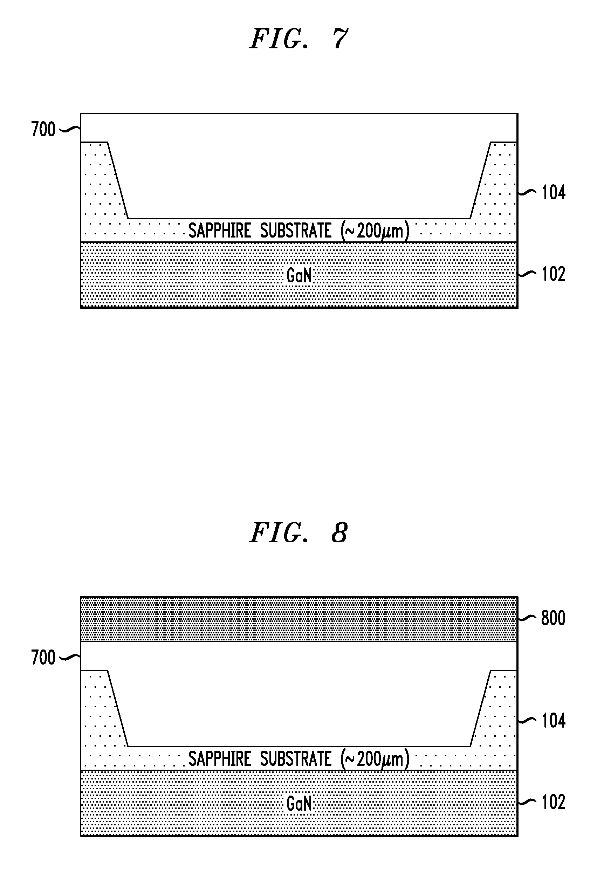

The passivation layers 400A and 400B are removed after etching the cavity 600, and a volume of resin material 700 is deposited in the cavity 600 as shown in FIG. 7. The resin material 700 is deposited by spinning on and planarizing an appropriate resin material. Poly methyl methacrylate (PMMA) is one example of an appropriate resin material. Embodiments, however, are not limited solely to the use of PMMA as a resin material. Instead, various other resin materials may be utilized.The cavity 600 defines a location for the lens structure 106 to be formed by reflowing the volume of resin material 700 deposited in the cavity 600.

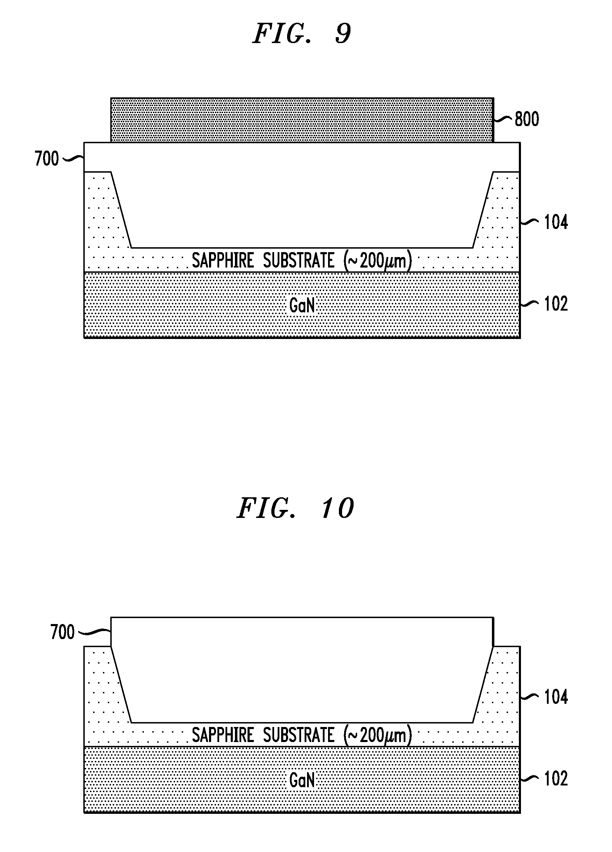

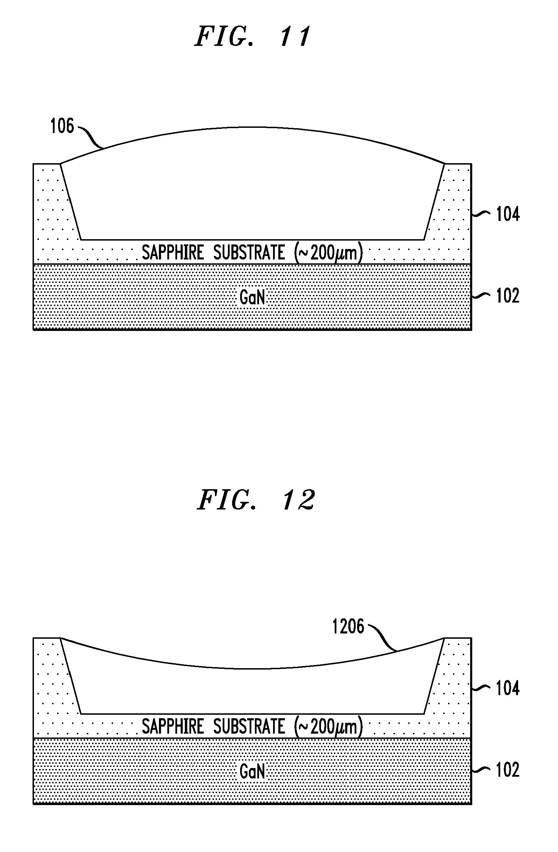

After depositing the resin material 700, a layer of photoresist is spun on as shown in FIG. 8. The photoresist 800 is patterned as shown in FIG. 9. Reactive ion etching (RIE) or another suitable process is utilized to remove the remaining photoresist 800 and resin material 700 left open as shown in FIG. 10. As a result, a square column of resin material 700 remains above the upper surface of the second side of the substrate 104. The next step is to reflow the resin material 700 to form the lens structure 106 as shown in FIG. 11. As described above, the lens structure 106 is a plano-convex cylindrical lens. The processing steps described above, however, may be modified in a suitable manner to form other lens types and geometries, examples of which are described below.

The n-contacts and p-contact are formed on the active semiconductor structure 102. Prior to formation of the corresponding solder bumps, a well-step-coverage SiO₂ passivation layer could be deposited by PECVD to preserve the active region sidewalls. Photolithography and wet etching processes can then be used to define the solder bump patterns. The solder bumps, which may comprise tin (Sn),would then be electroplated onto the contacts.

The above-described process operations are assumed to be performed at the wafer level, and the processed wafer is then separated into individual integrated circuits. A given one of the integrated circuits is arranged into a flip-chip package by bonding to the submount 108 as previously described.

As mentioned previously, the cavity formed in substrate 104 may take on a wide variety of different shapes in other embodiments. Examples of the different cavity shapes and lens structures which may be formed therein are shown and described in conjunction with the cross-sectional views of FIGS. 12-20.

FIG. 12 illustrates a plano-concave cylindrical lens structure 1206 in the cavity 600 described above.If the cavity 600 were formed in a circular opening rather than a square opening 500 or other rectangular opening, the plano-concave cylindrical lens structure 1206 would be a plano-concave spherical lens structure.

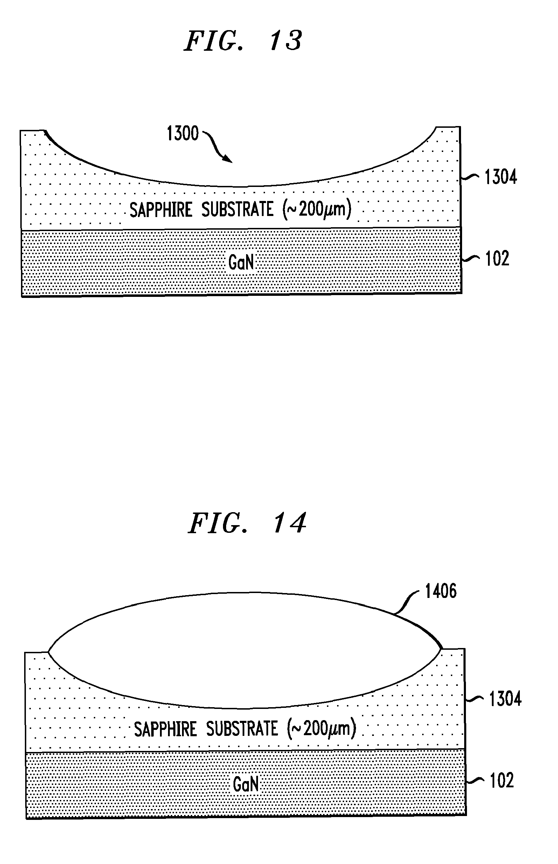

FIG. 13 shows a substrate 1304 with a cavity 1300 formed in a circular opening. The cavity 1300 has a curved shape. The curved shape is defined by a concave bottom surface and curved sidewalls which extend upwards from edges of the bottom surface to an upper surface of the second side of the substrate 1304. The shape of the cavity 1300 defines a portion of a sphere with a plane parallel to the upper surface of the second side of the substrate 1304.

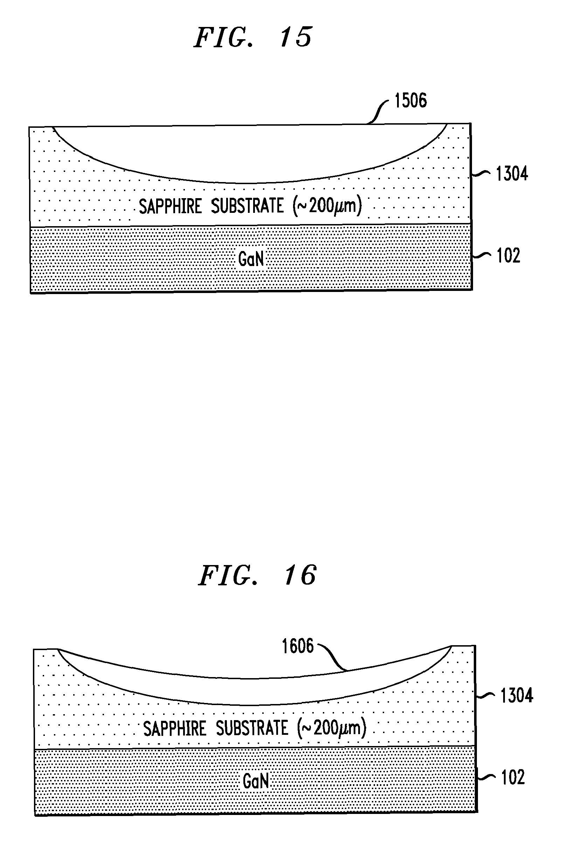

FIG. 14 illustrates a biconvex lens structure 1406 formed in the cavity 1300, FIG. 15 illustrates a plano-convex lens structure 1506 formed in the cavity 1300, and FIG. 16 illustrates a concavoconvex, periscopic convex, converging meniscus lens structure 1606 formed in the cavity 1300.

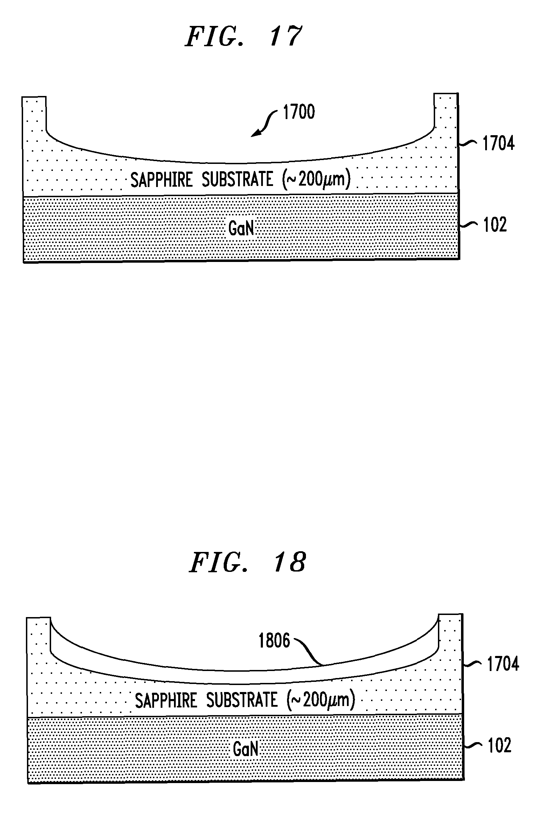

FIG. 17 shows a substrate 1704 with a cavity 1700 formed in a circular opening. The cavity 1700 has a concave bottom surface and a plurality of sidewalls which extend upward from edges of the bottom surface to an upper surface of the second side of the substrate 1704. FIG. 17 illustrates sidewalls which are substantially perpendicular to the upper surface of the substrate 1704. In other embodiments, the sidewalls may be angled in a non-perpendicular fashion.

FIG. 18 shows a convexoconcave, periscopic concave, diverging meniscus lens structure 1806 formed in the cavity 1700.

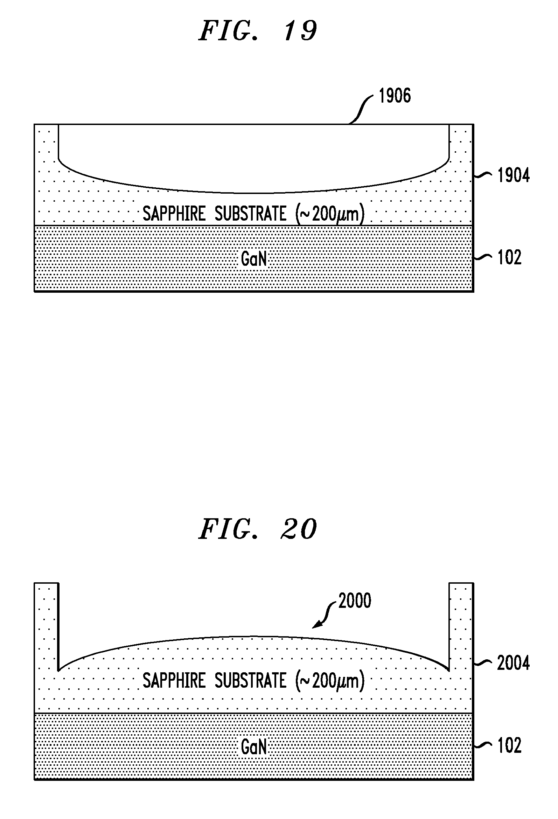

FIG. 19 shows a convex cylindrical lens structure 1906 formed in a cavity with a cross-sectional shape similar to that of cavity 1700. The cavity in FIG. 19 is formed in a rectangular opening in the substrate 1904, rather than the circular opening as in FIG. 17. The convex cylindrical lens structure 1906 is shown with the convex side of the lens structure facing towards the active semiconductor structure 102, rather than away from the active semiconductor structure 102 as in FIG. 1 and FIG. 11. Thus, the convex side of the cylindrical lens structure 1906 in FIG. 19 is considered to be "face-down" while the convex side of the cylindrical lens structure 106 in FIG. 11 is considered to be "face-up." It will be appreciated by one skilled in the art that various other lens structures described herein may similarly be formed "face-down" or "face-up" depending on the shape of a particular cavity.

FIG. 20 shows a substrate 2004 with a cavity 2000 formed in a circular opening. The cavity 2000 has a convex bottom surface and a plurality of sidewalls which extend upward from edges of the bottom surface to an upper surface of the second side of the substrate 2004. FIG. 20 illustrates sidewalls which are substantially perpendicular to the upper surface of the substrate 2004. In other embodiments, the sidewalls may be angled in a non-perpendicular fashion.

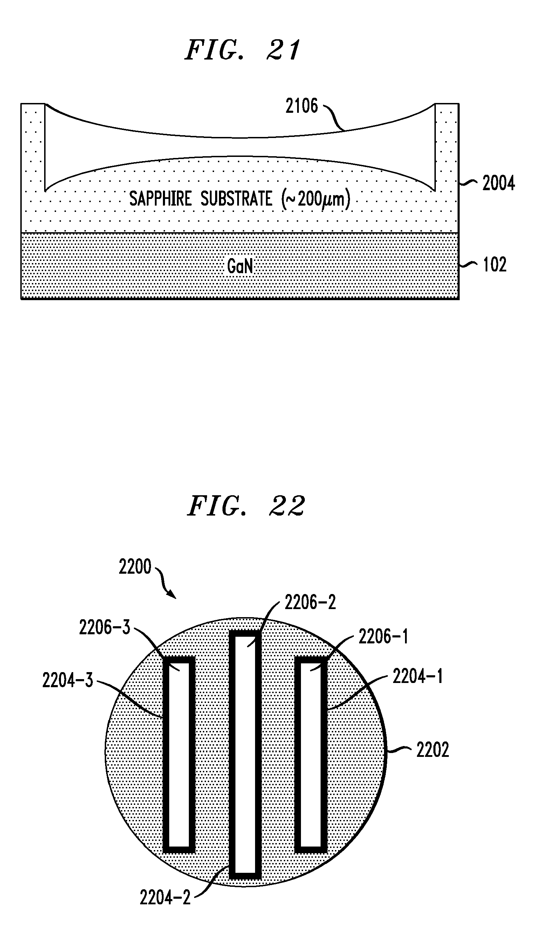

FIG. 21 shows a biconcave lens structure 2106 formed in the cavity 2000. As described above with respect to FIG. 19, lens structures may be formed in a face-down or face-up manner. For example, a plano-concave lens structure may be formed in the cavity 2000 with the concave side of the lens facing towards the active semiconductor structure 102. Various other lens structures may be formed in the cavity 2000, including various meniscus lens structures and a concave cylindrical lens, where the concave side of the cylindrical lens faces towards the active semiconductor structure 102.

Numerous other cavity shapes and lens structures are possible. In addition, more than one lens structure may be formed side-by-side in a single cavity. Multiple lens structures may also be stacked on top of one another. For example, a cavity may have stepped sidewalls, such that lens structures of varying diameters and/or varying types may be formed in the cavity. The term cavity as used herein is intended to be broadly construed so as to encompass these and other arrangements.

One skilled in the art would know that various lens structures can be utilized to focus light along desired paths.The particular cavity shapes and lens structures formed in a given semiconductor optical emitting device may be selected based on a particular application or intended use.

Embodiments of the invention allow the formation of complex or compound lens structures within a cavity of the substrate. Complex and compound lens structures include a number of non-hemispherical lens structures such as those described above. The use of compound lens structures provides a number of distinct advantages relative to conventional techniques, including but not limited to: the formation of complex shapes and patterns of lens structures, improved optical characteristics such as reduced aberrations, suppressing internal reflections, and improved external quantum efficiency and optical coupling of light emitted from a semiconductor optical emitting device.

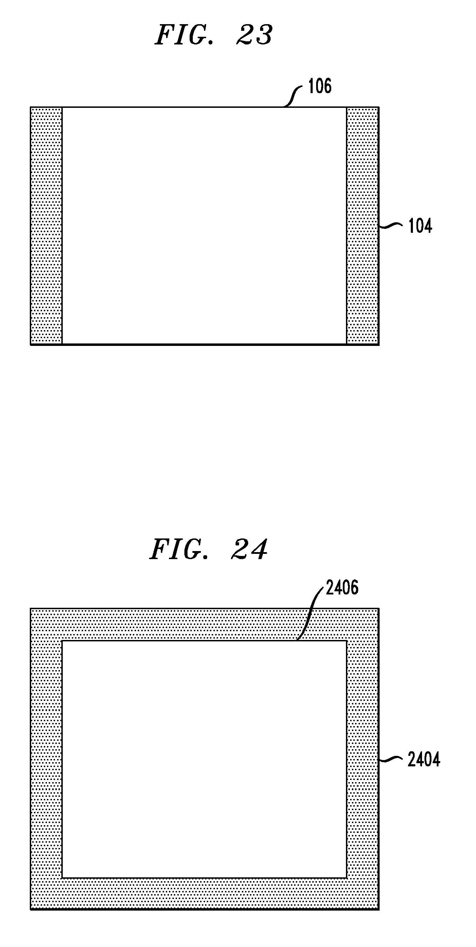

FIG. 22 shows a top-down view of a wafer 2200. The wafer 2200 has an active semiconductor structure 2202 on which substrates 2204-1, 2204-2 and 2204-3 are formed. The substrates 2204-1, 2204-2 and 2204-3 each have a cavity in which lens structures 2206-1, 2206-2 and 2206-3 are formed, respectively. As shown in FIG. 22, the cavities are defined to run a length of the wafer 2200 and are truncated before reaching the edge of the wafer 2200. The wafer 2200 may be separated into a number of individual die. FIG. 23 shows a top-down view of a single die formed from the wafer 2200. The left and right edges of the lens structure 106 are defined by the cavity in which the lens structure 106 is formed, while the top and bottom edges of the lens structure 106 are defined during separation of the wafer 2200 into the single die shown in FIG. 23.

As described above, the lens structure 106 may be formed by depositing a resin material into a cavity and reflowing the resin material to obtain the convex cylindrical lens geometry. The reflow process will pull the resin material deposited in the cavity toward edges of the cavity.In some embodiments, the long trough cavities shown in the wafer 2200 of FIG. 22 are used to accurately achieve,for example, a convex or concave surface geometry over the length of the trough cavity before dicing or otherwise separating the wafer 2200 into individual die.

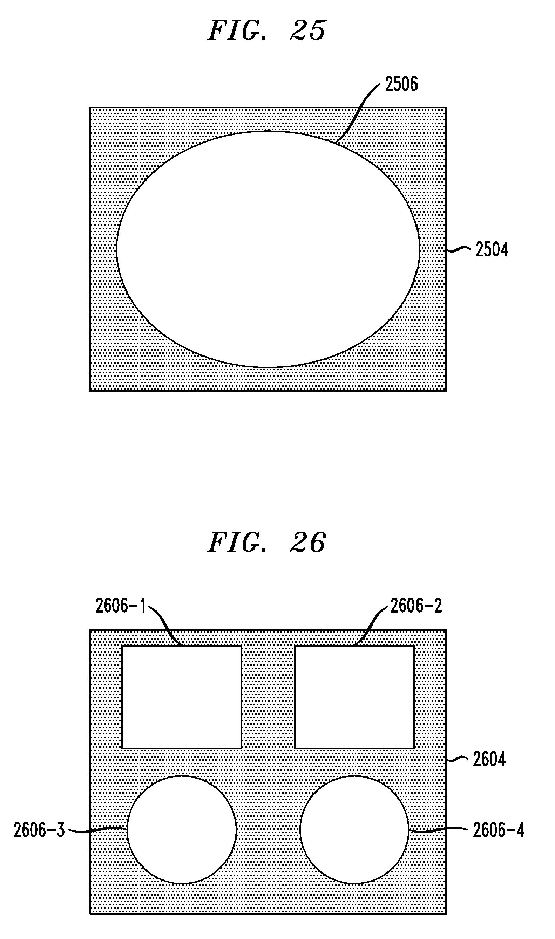

In other embodiments, the edges of the lens structure may be defined solely by the cavity in which it is formed. FIG. 24 shows a top-down view of a cylindrical lens structure 2406 formed in a rectangular cavity of a substrate 2404. The left, right, top and bottom edges of the cylindrical lens structure are defined by the rectangular cavity of the substrate 2404 in which the lens structure 2406 is formed. FIG. 25 shows a top-down view of a spherical lens structure 2506 formed in a circular cavity of a substrate 2504. The edges of the spherical lens structure 2506 are defined by the circular cavity of the substrate 2504 in which the lens structure 2506 is formed. The spherical lens may be one of a number of spherical geometries including but not limited to biconvex, biconcave, plano-convex, plano-concave and meniscus geometries.

FIG. 26 shows a substrate 2604 with a number of lens structures formed in cavities therein. The substrate 2604 has four distinct cavities in which lens structures 2606-1 through 2606-4 are formed. As shown in FIG. 26, a combination of cylindrical lens structures 2606-1 and 2606-2 and spherical lens structures 2606-3 and 2606-4 are formed. Various other combinations are possible, including a substrate with more or less than four cavities, as well as more or less than two different cavity shapes. In addition, as indicated above, a given cavity may be shaped such that two or more lens structures are formed in a single cavity.

As mentioned previously, semiconductor optical emitting devices such as those described above can be implemented in the form of integrated circuits. In a given such integrated circuit implementation, identical die are typically formed in a repeated pattern on a surface of a semiconductor wafer. Each die includes circuitry as described herein, and may include other structures or circuits. The individual die are cut or diced from the wafer, then packaged as an integrated circuit. One skilled in the art would know how to dice wafers and package die to produce integrated circuits. Integrated circuits so manufactured are considered embodiments of the invention.

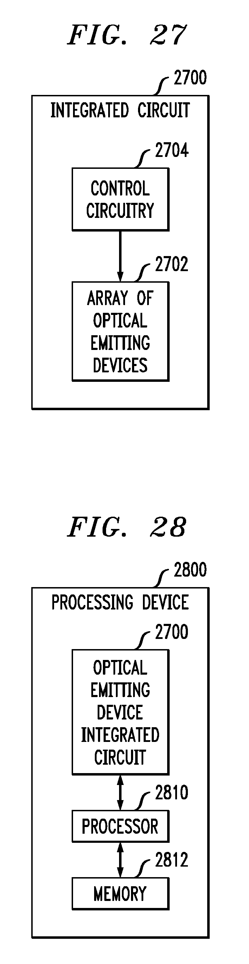

FIG. 27 shows one example of an integrated circuit embodiment of the invention. In this embodiment, an integrated circuit 2700 comprises an array 2702 of SELs 100 each configured as previously described in conjunction with FIG. 1. Control circuitry 2704 is coupled to the array 2702 of SELsand is configured to controlgeneration of light by those SELs. The integrated circuit 2700 may be implemented in a lighting system, an electronic display or another type of system or device.

As another example, a given optical emitting device integrated circuit 2700 may be incorporated into a processing device 2800 as illustrated in FIG. 28. Such a processing device may comprise a laptop or tablet computer, a mobile telephone, an e-reader or another type of processing device that utilizes one or more SEL integrated circuits to provide back lighting or for other functions.

In the processing device 2800, the optical emitting device integrated circuit 2700 is coupled to a processor 2810 that controls generation of light by the corresponding array of SELs.

The processor 2810 may comprise, for example, a microprocessor, an application-specific integrated circuit (ASIC), a field-programmable gate array (FPGA), a central processing unit (CPU), an arithmetic logic unit (ALU), a digital signal processor (DSP), or other similar processing device component, as well as other types and arrangements of circuitry, in any combination.

The processor 2810 is coupled to a memory 2812.The memory 2812 stores software code for execution by the processor 2810 in implementing portions of the functionality of the processing device 2800.A given such memory that stores software code for execution by a corresponding processor is an example of what is more generally referred to herein as a computer-readable medium or other type of computer program product having computer program code embodied therein, and may comprise, for example, electronic memory such as random access memory (RAM) or read-only memory (ROM), magnetic memory, optical memory, or other types of storage devices in any combination. As indicated above, the processor may comprise portions or combinations of a microprocessor, ASIC, FPGA, CPU, ALU, DSP or other circuitry. Such circuitry components utilized to implement the processor may comprise one or more integrated circuits.

The particular configurations of integrated circuit 2700 and processing device 2800 as shown in respective FIGS. 27 and 28are exemplary only, and in other embodiments integrated circuits and processing devices may include other elements in addition to or in place of those specifically shown, including one or more elements of a type commonly found in conventional implementations of such circuits and devices.

It should again be emphasized that the embodiments of the invention as described herein are intended to be illustrative only. For example, other embodiments of the invention can be implemented utilizing a wide variety of different types and arrangements of semiconductor optical emitting devices, active semiconductor structures, substrates, cavities and lens structures otherthan those utilized in theparticular embodiments described herein.Also, the particular process operations and associated parameters such as materials, thicknesses, solutions and temperatures are exemplary only. In addition, the particular assumptions made herein in the context of describing certain embodiments need not apply in other embodiments. These and numerous other alternative embodiments within the scope of the following claims will be readily apparent to those skilled in the art.

## Claims

1. A semiconductor optical emitting device comprising:
an at least partially transparent substrate;
an active semiconductor structure arranged on a first side of the substrate; and
a lens structure formed at least partially within a cavity on a second side of the substrate;
wherein light generated by the active semiconductor structure is emitted through the substrate and the lens structure.

2. The device of claim 1 wherein the device is implemented as one of a semiconductor laser and a light emitting diode.

3. The device of claim 1, wherein the lens structure is formed by depositing a volume of resin material in the cavity and reflowing the volume of resin material, the resin material comprising poly methyl methacrylate.

4. The device of claim 1, wherein the lens structure comprises a non-hemispherical lens.

5. The device of claim 1, wherein the lens structure comprises a spherical lens structure implemented as one of: a biconvex lens, a biconcave lens, a plano-convex lens, a plano-concave lens, and a meniscus lens.

6. The device of claim 1, wherein the lens structure comprises a cylindrical lens structure.

7. The device of claim 1, wherein:
the cavity comprises a bottom surface and a plurality of sidewalls, the plurality of sidewalls extending upward from the bottom surface to an upper surface of the second side of the substrate; and
the bottom surface is convex.

8. The device of claim 1, wherein:
the cavity comprises a bottom surface and a plurality of sidewalls, the plurality of sidewalls extending upward from the bottom surface to an upper surface of the second side of the substrate; and
the bottom surface is concave.

9. The device of claim 1, wherein:
the cavity comprises a bottom surface and a plurality of sidewalls, the plurality of sidewalls extending upward from the bottom surface to an upper surface of the second side of the substrate; and
the bottom surface and the plurality of sidewalls form a portion of a sphere with a plane parallel to the upper surface of the second side of the substrate.

10. The device of claim 1, wherein the substrate comprises a plurality of lens structures formed within respective ones of a plurality of cavities formed on the second side of the substrate.

11. A method comprising:
forming an active semiconductor structure on a first side of an at least partially transparent substrate;
forming a cavity on a second side of the substrate; and
forming a lens structure at least partially within the cavity;
wherein light generated by the active semiconductor structure is emitted through the substrate and the lens structure.

12. An apparatus comprising:
one or more semiconductor optical emitting devices; and
control circuitry coupled to said one or more semiconductor optical emitting devices for controlling generation of light by said one or more semiconductor optical emitting devices;
at least a given one of the one or more semiconductor optical emitting devices comprising:
an at least partially transparent substrate;
an active semiconductor structure arranged on a first side of the substrate; and
a lens structure formed at least partially within a cavity on a second side of the substrate;
wherein light generated by the active semiconductor structure is emitted through the substrate and the lens structure.

13. The apparatus of claim 12 wherein the one or more semiconductor optical emitting devices comprise an array of semiconductor optical emitting devices coupled to the control circuitry.

14. The apparatus of claim 12 wherein the one or more semiconductor optical emitting devices and the control circuitry are implemented in one of a lighting system and an electronic display.

15. An integrated circuit comprising the apparatus of claim 12.
